# EUROPEAN PATENT SPECIFICATION

(11) **EP 4 517 075 B1**
(45) Date of publication and mention of the grant of the patent: **02.12.2026**
(21) Application number: 24191729.3
(22) Date of filing: 30.07.2024
(51) Int. Cl.: F02C 7/16, F02C 7/25, F02C 7/32

(54) **A POWER ELECTRONICS COOLING ASSEMBLY**
KÜHLANORDNUNG FÜR LEISTUNGSELEKTRONIK
ENSEMBLE DE REFROIDISSEMENT D'ÉLECTRONIQUE DE PUISSANCE

(30) Priority: 30.08.2023 GB 202313138
(43) Date of publication of application: 05.03.2025
(73) Proprietor: Rolls-Royce plc, London N1 9FX (GB)
(72) Inventor: Murray, Christopher, Derby, DE24 8BJ (GB)
(74) Representative: Rolls-Royce plc

(56) References cited:
- US-A- 3 733 816
- US-A1- 2010 242 492
- US-A1- 2022 381 185
- US-A1- 2023 243 306
- ANONYMOUS: "Silco Sleeve Firesleeve | Hose & Cable Protection | Davlyn Group", 2 June 2023 (2023-06-02), pages 1 - 6, XP093238756, Retrieved from the Internet <URL:https://web.archive.org/web/20230602025524/https://www.davlyngroup.com/web/20230602025524/https://www.davlyngroup.com/products/firesleeve/> [retrieved on 20250113]

## Description

### TECHNICAL FIELD

The present disclosure relates to a power electronics cooling assembly, particularly for cooling power electronics of a gas turbine engine. The present disclosure also concerns a gas turbine engine assembly comprising the power electronics cooling assembly.

### BACKGROUND

It is known to pressurise a cabin of an aircraft using an air pressurisation system which makes use of engine bleed air which is bled from a compressor section of the core of a gas turbine engine. Bleeding high pressure air from the gas turbine engine reduces its efficiency and thereby increases its fuel consumption.

It is therefore desirable to provide an improved air pressurisation system. Air pressurisation systems which make use of air which is taken from a lower pressure source of a gas turbine engine, such as a bypass duct, and which subsequently compress the air prior to delivering it to the cabin are also known. Some exemplary air pressurisation systems are described in EP3517436 B1, EP3517437 B1 and EP3517438 B1.

It is typically desirable for power electronics, e.g., for systems of a gas turbine engine, such as an improved air pressurisation system, to be located where the ambient temperature is low, due to the need to maintain semiconductor junction temperatures of the power electronics at a suitable level. However, even when power electronics are positioned in relatively low temperature locations within a gas turbine engine assembly, it can remain desirable to actively cool the power electronics.

It may therefore be desirable to provide an assembly for locating and suitably cooling power electronics for systems of gas turbine engines.

US 2023/243306 relates to a combination of a gas turbine engine and a power electronics for powering aircraft and/or engine systems. The power electronics is configured to transfer heat produced by the power electronics to a cooling flow formed by a portion of the fuel flow. The fuel circuit is configured to circulate the cooling flow in a loop during selected engine conditions such that the cooling flow transfers heat from the power electronics to a phase change material located on the loop. The phase change material has a phase change temperature at a predetermined limiting temperature whereby the phase change material stores heat from the cooling flow to prevent the power electronics exceeding the limiting temperature.

### SUMMARY

According to an aspect of the present disclosure, there is provided a power electronics cooling assembly, the assembly comprising: a housing for power electronics, wherein the housing is mountable to a bulkhead, for separating a fire zone from a non-fire zone, such as a flammable fluid zone, of a gas turbine engine, in the non-fire zone; one or more ducts for extending from the bulkhead to the housing; a fluid supply pipe and a return pipe for extending through the one or more ducts from the bulkhead to the housing, wherein the fluid supply and return pipes are for carrying an ignitable fluid coolant; and a heat exchange structure arranged within the housing, wherein the heat exchange structure is configured to receive the ignitable fluid coolant from the fluid supply pipe, facilitate transfer of heat from the power electronics within the housing to the ignitable fluid coolant, and output the ignitable fluid coolant to the fluid return pipe. The assembly comprises anti-vibration mounts for mounting the housing to the bulkhead.

The duct, and/or the fluid supply and/or return pipes may be resiliently deformable. The duct, and/or the fluid supply and/or return pipes may be coupled to the housing. The duct, and/or the fluid supply and/or return pipes may be sealingly coupleable to the bulkhead.

A wall of the one or more duct may comprise a plurality of corrugations for enabling resilient deformation of the duct. The one or more ducts may formed from a fireproof material, such as a fireproof rubber, e.g., Kalrez.

The assembly may comprise a first duct for extending from bulkhead to the housing and a second duct for extending from the bulkhead to the hosing. The fluid supply pipe may extend through the first duct and the fluid return pipe may extend through the second duct.

The assembly may further comprise fluid supply and return pipe couplings for respectively coupling the fluid supply and return pipes to rigid fluid pipes at or on an opposite side of the bulkhead from the housing.

A system may comprise an electrical machine operatively couplable to a spool of a gas turbine engine; power electronics for controlling the operation of the electrical machine; and the above-mentioned power electrics cooling assembly, wherein the power electronics are housed within the housing.

The electrical machine may be configured, in first operating mode of the system, to operate as a generator to receive power from the spool of the gas turbine engine and supply electrical power to the power electronics. In a second operating mode of the system, the electrical machine may be configured to operate as a motor to crank the gas turbine engine.

The system may further comprise a blower compressor configured to be mechanically coupled to a spool of a gas turbine engine. The blower compressor may be configured to receive an inlet flow of air from a bypass duct of the gas turbine engine and supply compressed air to an airframe. The system may further comprise a transmission for mechanically coupling the spool of the gas turbine engine to a rotor of the blower compressor. The system may further comprise a further electrical machine operatively connected to the transmission, wherein the power electronics is configured to control the operation of the further electrical machine in order to vary a speed of the transmission relative to a speed of the spool. The further electrical machine may be configured to be driven by the rotor of the blower compressor and operate as a generator to supply power to the power electronics for powering the electrical machine.

A gas turbine engine assembly may comprise a gas turbine engine having a core; a bulkhead disposed at least partially about the core of a gas turbine engine; and the above-mentioned power electronics cooling assembly or the above-mentioned system, wherein the housing is coupled to the bulkhead. The housing may be coupled to the bulkhead on an opposite side of the bulkhead from the core of the gas turbine engine, e.g., axially forward, aft, port, or starboard of the core.

An aircraft may comprise an airframe, and the above-mentioned gas turbine engine assembly.

As noted elsewhere herein, the present disclosure may relate to a gas turbine engine. Such a gas turbine engine may comprise an engine core comprising a turbine, a combustor, a compressor, and a core shaft connecting the turbine to the compressor. Such a gas turbine engine may comprise a fan (having fan blades) located upstream of the engine core.

Arrangements of the present disclosure may be particularly, although not exclusively, beneficial for fans that are driven via a gearbox. Accordingly, the gas turbine engine may comprise a gearbox that receives an input from the core shaft and outputs drive to the fan so as to drive the fan at a lower rotational speed than the core shaft. The input to the gearbox may be directly from the core shaft, or indirectly from the core shaft, for example via a spur shaft and/or gear. The core shaft may rigidly connect the turbine and the compressor, such that the turbine and compressor rotate at the same speed (with the fan rotating at a lower speed).

The gas turbine engine as described and/or claimed herein may have any suitable general architecture. For example, the gas turbine engine may have any desired number of shafts that connect turbines and compressors, for example one, two or three shafts. Purely by way of example, the turbine connected to the core shaft may be a first turbine, the compressor connected to the core shaft may be a first compressor, and the core shaft may be a first core shaft. The engine core may further comprise a second turbine, a second compressor, and a second core shaft connecting the second turbine to the second compressor. The second turbine, second compressor, and second core shaft may be arranged to rotate at a higher rotational speed than the first core shaft.

In such an arrangement, the second compressor may be positioned axially downstream of the first compressor. The second compressor may be arranged to receive (for example directly receive, for example via a generally annular duct) flow from the first compressor.

The gearbox may be arranged to be driven by the core shaft that is configured to rotate (for example in use) at the lowest rotational speed (for example the first core shaft in the example above). For example, the gearbox may be arranged to be driven only by the core shaft that is configured to rotate (for example in use) at the lowest rotational speed (for example only be the first core shaft, and not the second core shaft, in the example above). Alternatively, the gearbox may be arranged to be driven by any one or more shafts, for example the first and/or second shafts in the example above.

The gearbox may be a reduction gearbox (in that the output to the fan is a lower rotational rate than the input from the core shaft). Any type of gearbox may be used. For example, the gearbox may be a "planetary" or "star" gearbox, as described in more detail elsewhere herein.

In any gas turbine engine as described and/or claimed herein, a combustor may be provided axially downstream of the fan and compressor(s). For example, the combustor may be directly downstream of (for example at the exit of) the second compressor, where a second compressor is provided. By way of further example, the flow at the exit to the combustor may be provided to the inlet of the second turbine, where a second turbine is provided. The combustor may be provided upstream of the turbine(s).

The or each compressor (for example the first compressor and second compressor as described above) may comprise any number of stages, for example multiple stages. Each stage may comprise a row of rotor blades and a row of stator vanes, which may be variable stator vanes (in that their angle of incidence may be variable). The row of rotor blades and the row of stator vanes may be axially offset from each other.

The or each turbine (for example the first turbine and second turbine as described above) may comprise any number of stages, for example multiple stages. Each stage may comprise a row of rotor blades and a row of stator vanes. The row of rotor blades and the row of stator vanes may be axially offset from each other.

### BRIEF DESCRIPTION OF THE DRAWINGS

Embodiments will now be described by way of example only with reference to the accompanying drawings, which are purely schematic and not to scale, and in which:
**FIG. 1** is a sectional side view of a gas turbine engine;
**FIG. 2** is a close up sectional side view of an upstream portion of a gas turbine engine;
**FIG. 3** is a partially cut-away view of a gearbox for a gas turbine engine;
**FIG. 4** is a schematic view of an air pressurisation system, according to arrangements of the present disclosure, for supplying air to an airframe system;
**FIG. 5** is a schematic view of a power electronics cooling assembly for the air pressurisation system shown in FIG. 4, according to arrangements of the present disclosure;
**FIG. 6** is a schematic view of another power electronics cooling assembly for the air pressurisation system shown in FIG. 4, according to arrangements of the present disclosure;
**FIG. 7** is a schematic view of another power electronics cooling assembly for the air pressurisation system shown in FIG. 4, according to arrangements of the present disclosure; and
**FIG. 8** is a schematic diagram of an aircraft including an airframe, a gas turbine engine and an air pressurisation system.

### DETAILED DESCRIPTION

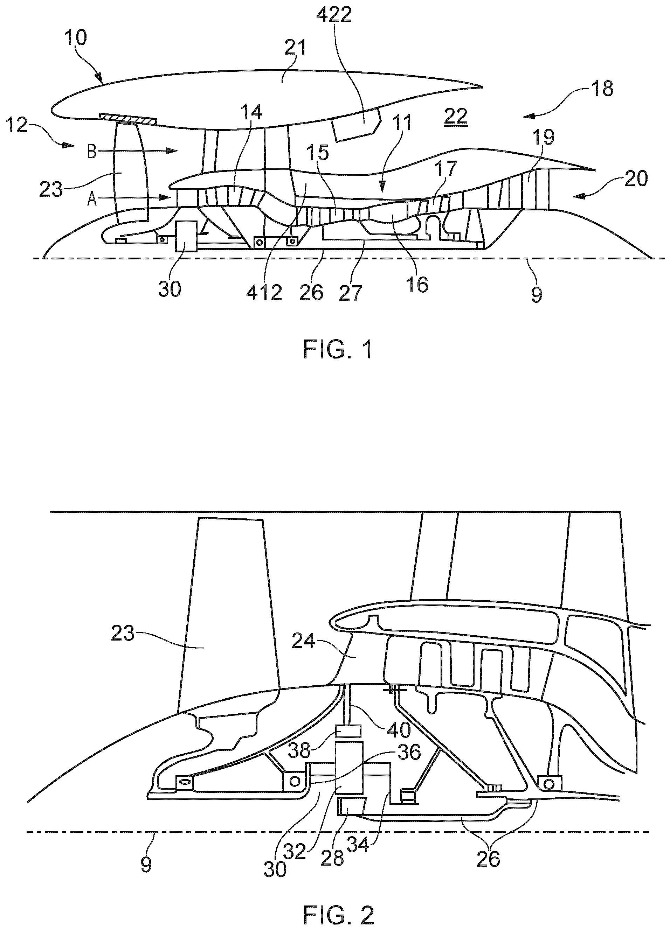

**FIG. 1** illustrates a gas turbine engine 10 having a principal rotational axis 9. The engine 10 comprises an air intake 12 and a propulsive fan 23 that generates two airflows: a core airflow A and a bypass airflow B. The gas turbine engine 10 comprises a core 11 that receives the core airflow A. The engine core 11 comprises, in axial flow series, a low pressure compressor 14, a high-pressure compressor 15, combustion equipment 16, a high-pressure turbine 17, a low pressure turbine 19 and a core exhaust nozzle 20. A nacelle 21 surrounds the gas turbine engine 10 and defines a bypass duct 22 and a bypass exhaust nozzle 18. The bypass airflow B flows through the bypass duct 22. The bypass duct 22 may comprise an engine bypass duct port 422 for supplying air from the bypass duct to an air pressurisation system or the like. The engine core 11 may also comprise an engine core port for supplying air from a compressor stage of the engine core 11 (such as the low pressure compressor 14 or the high-pressure compressor 15) to an air pressurisation system or the like. The fan 23 is attached to and driven by the low pressure turbine 19 via a shaft 26 and an epicyclic gearbox 30.

In use, the core airflow A is accelerated and compressed by the low pressure compressor 14 and directed into the high pressure compressor 15 where further compression takes place. The compressed air exhausted from the high pressure compressor 15 is directed into the combustion equipment 16 where it is mixed with fuel and the mixture is combusted. The resultant hot combustion products then expand through, and thereby drive, the high pressure and low pressure turbines 17, 19 before being exhausted through the nozzle 20 to provide some propulsive thrust. The high pressure turbine 17 drives the high pressure compressor 15 by a suitable interconnecting shaft 27. The fan 23 generally provides the majority of the propulsive thrust. The epicyclic gearbox 30 is a reduction gearbox.

An exemplary arrangement for a geared fan gas turbine engine 10 is shown in **FIG. 2****.** The low pressure turbine 19 (see FIG. 1) drives the shaft 26, which is coupled to a sun wheel, or sun gear, 28 of the epicyclic gear arrangement 30. Radially outwardly of the sun gear 28 and intermeshing therewith is a plurality of planet gears 32 that are coupled together by a planet carrier 34. The planet carrier 34 constrains the planet gears 32 to precess around the sun gear 28 in synchronicity whilst enabling each planet gear 32 to rotate about its own axis. The planet carrier 34 is coupled via linkages 36 to the fan 23 in order to drive its rotation about the engine axis 9. Radially outwardly of the planet gears 32 and intermeshing therewith is an annulus or ring gear 38 that is coupled, via linkages 40, to a stationary supporting structure 24.

Note that the terms "low pressure turbine" and "low pressure compressor" as used herein may be taken to mean the lowest pressure turbine stages and lowest pressure compressor stages (i.e., not including the fan 23) respectively and/or the turbine and compressor stages that are connected together by the interconnecting shaft 26 with the lowest rotational speed in the engine (i.e., not including the gearbox output shaft that drives the fan 23). In some literature, the "low pressure turbine" and "low pressure compressor" referred to herein may alternatively be known as the "intermediate pressure turbine" and "intermediate pressure compressor". Where such alternative nomenclature is used, the fan 23 may be referred to as a first, or lowest pressure, compression stage.

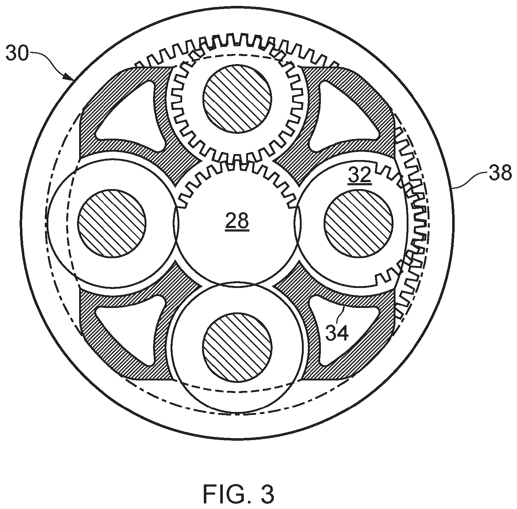

The epicyclic gearbox 30 is shown by way of example in greater detail in **FIG. 3****.** Each of the sun gear 28, planet gears 32 and ring gear 38 comprise teeth about their periphery to intermesh with the other gears. However, for clarity only exemplary portions of the teeth are illustrated in FIG. 3. There are four planet gears 32 illustrated, although it will be apparent to the skilled reader that more or fewer planet gears 32 may be provided within the scope of the claimed invention. Practical applications of a planetary epicyclic gearbox 30 generally comprise at least three planet gears 32.

The epicyclic gearbox 30 illustrated by way of example in FIGS. 2 and 3 is of the planetary type, in that the planet carrier 34 is coupled to an output shaft via linkages 36, with the ring gear 38 fixed. However, any other suitable type of epicyclic gearbox 30 may be used. By way of further example, the epicyclic gearbox 30 may be a star arrangement, in which the planet carrier 34 is held fixed, with the ring (or annulus) gear 38 allowed to rotate. In such an arrangement the fan 23 is driven by the ring gear 38. By way of further alternative example, the gearbox 30 may be a differential gearbox in which the ring gear 38 and the planet carrier 34 are both allowed to rotate.

It will be appreciated that the arrangement shown in FIGS. 2 and 3 is by way of example only, and various alternatives are within the scope of the present disclosure. Purely by way of example, any suitable arrangement may be used for locating the gearbox 30 in the engine 10 and/or for connecting the gearbox 30 to the engine 10. By way of further example, the connections (such as the linkages 36, 40 in the FIG. 2 example) between the gearbox 30 and other parts of the engine 10 (such as the input shaft 26, the output shaft and the fixed structure 24) may have any desired degree of stiffness or flexibility. By way of further example, any suitable arrangement of the bearings between rotating and stationary parts of the engine (for example between the input and output shafts from the gearbox and the fixed structures, such as the gearbox casing) may be used, and the disclosure is not limited to the exemplary arrangement of FIG. 2. For example, where the gearbox 30 has a star arrangement (described above), the skilled person would readily understand that the arrangement of output and support linkages and bearing locations would typically be different to that shown by way of example in FIG. 2.

Accordingly, the present disclosure extends to a gas turbine engine having any arrangement of gearbox styles (for example star or planetary), support structures, input and output shaft arrangement, and bearing locations.

Optionally, the gearbox may drive additional and/or alternative components (e.g., the intermediate pressure compressor and/or a booster compressor).

Other gas turbine engines to which the present disclosure may be applied may have alternative configurations. For example, such engines may have an alternative number of compressors and/or turbines and/or an alternative number of interconnecting shafts. By way of further example, the gas turbine engine shown in FIG. 1 has a split flow nozzle 18, 20 meaning that the flow through the bypass duct 22 has its own nozzle 18 that is separate to and radially outside the core engine nozzle 20. However, this is not limiting, and any aspect of the present disclosure may also apply to engines in which the flow through the bypass duct 22 and the flow through the core 11 are mixed, or combined, before (or upstream of) a single nozzle, which may be referred to as a mixed flow nozzle. One or both nozzles (whether mixed or split flow) may have a fixed or variable area. Whilst the described example relates to a turbofan engine, the disclosure may apply, for example, to any type of gas turbine engine, such as an open rotor (in which the fan stage is not surrounded by a nacelle) or turboprop engine, for example. In some arrangements, the gas turbine engine 10 may not comprise a gearbox 30.

The geometry of the gas turbine engine 10, and components thereof, is defined by a conventional axis system, comprising an axial direction (which is aligned with the rotational axis 9), a radial direction (in the bottom-to-top direction in FIG. 1), and a circumferential direction (perpendicular to the page in the FIG. 1 view). The axial, radial and circumferential directions are mutually perpendicular.

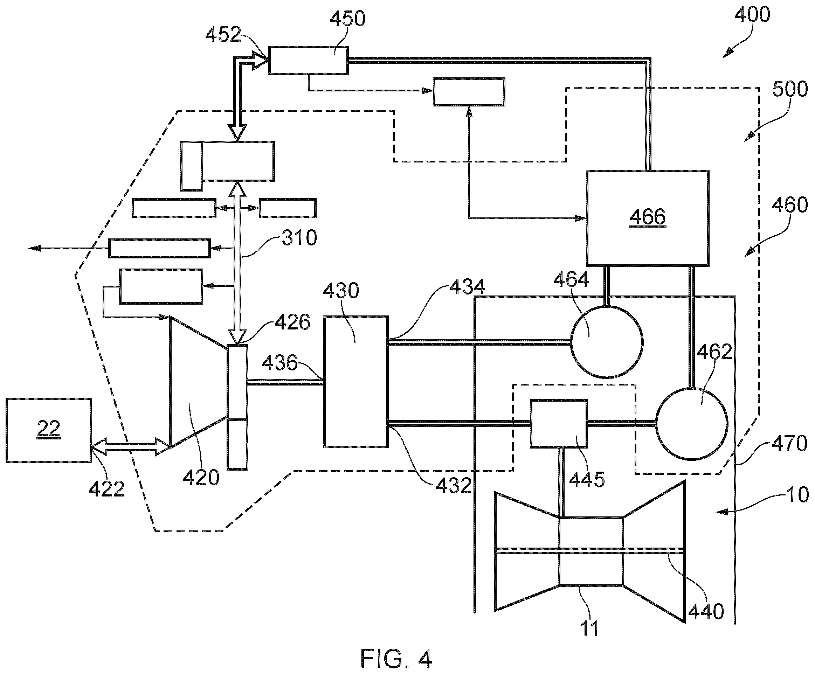

A system, e.g., an air pressurisation system 400, according to arrangements of the present disclosure, is shown schematically in **FIG. 4****.** The air pressurisation system 400 is for supplying air to an airframe system 450. The air pressurisation system 400 comprises a blower compressor 420 configured to be mechanically coupled to a spool 440 of a gas turbine engine, such as the gas turbine engine 10. The expression "spool" is used herein to denote a shaft of the engine which interconnects a compressor and a turbine of the engine core 11, and/or engine components which rotate together with such an engine shaft (e.g., the compressor and turbine interconnected by the shaft, and associated rotating components such as drums and disks).

The blower compressor 420 is configured to operate in a first mode of operation, which may be referred to as a blower mode, in which the blower compressor 420 is driven to rotate by the spool 440 to draw an inlet flow of gases from an engine bypass duct port 422. The engine bypass duct port 422 is in fluid communication with a bypass duct 22 of the gas turbine engine. Accordingly, when operated in the blower mode, the blower compressor 420 is configured to receive the inlet flow of air from the bypass duct 22 of the gas turbine engine. Flows of gases referred to within the present specification, such as the inlet flow of gases and the compressed gases discharged from the blower compressor may be, or be substantially comprised of, compressed air. Unless otherwise specified, the terms "flows of gases" and "flows of air" may be used interchangeably herein. It will be appreciated that when a flow of gases is referred to as a flow of air, then the flow may additionally comprise one or more other gases and/or contaminants, such as oil, oil mist, volatile organic compounds, burnt and unburnt hydrocarbons and/or any other contaminants present within the flow of air/gases.

The blower compressor 420 is configured to discharge compressed gases to a blower compressor discharge port 426 for supply to an airframe port 452 for an airframe air use (i.e., a particular application or purpose for which the air is supplied to the airframe). A delivery line 310 extends from the blower compressor discharge port 426 to the airframe port 452. The airframe port 452 is in, or configured to be in, fluid communication with the airframe system 450. The airframe air use may be, for example, one or more of wing anti-icing, fuel tank inerting, cargo bay smoke eradication, aircraft cabin pressurisation or cargo bay smoke eradication.

The blower compressor 420 is generally configured to compress the inlet flow of air by converting kinetic energy of the inlet flow of air into pressure energy and heat energy. The blower compressor 420 may be any suitable type of compressor. As shown in the FIG. 4, the blower compressor 420 may preferably be a centrifugal compressor.

The air pressurisation system 400 further comprises a variable transmission 430 for mechanically coupling the blower compressor 420 to the spool 440. The variable transmission 430 allows a rotational speed of the blower compressor 420 to be decoupled from a rotational speed of the spool 440, so that a performance of the air pressurisation system 400 is not solely governed by an operating speed of the gas turbine engine (e.g., it can be controlled to operate at a target speed independent of the rotational speed of the spool, and/or at a variable speed ratio relative to the rotational speed of the spool). Inclusion of a variable transmission 430 within the air pressurisation system 400 therefore provides more versatile and adaptable means for supplying pressurised air to an airframe system. Various suitable variable transmission types will be apparent to those of ordinary skill in the art.

The variable transmission 430 comprises a first input 432 configured to receive drive from the spool 440 of the gas turbine engine. The gas turbine engine may comprise an accessory gearbox 445 coupled to the spool 440, and the variable transmission 430 may be coupled to the spool 440 via the accessory gearbox 445.

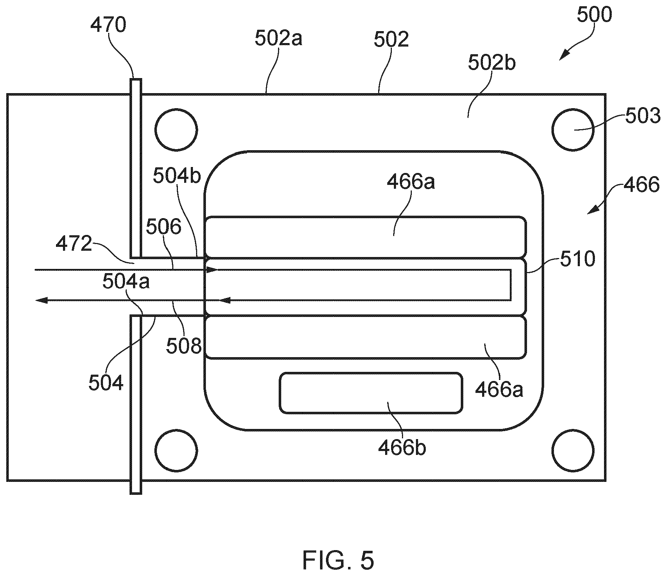

As depicted, the air pressurisation system 400 may further comprise an electrical variator 460 for varying the speed of an output 436 of the variable transmission 430 relative to the speed of the input provided to the first input 432, e.g., from the spool 440. The electrical variator 460 may comprise a first electrical machine 462, a second electrical machine 464 and an electrical power management system 466 operatively coupled to the first and second electrical machines 462, 464, as described in greater detail below with reference to FIGS. 5, 6 and 7, the electrical power management system may be provided as part of a power electronics cooling assembly 500.

The first electrical machine 462 may be a motor-generator, and may be operatively coupled to the spool 440. In particular, the first electrical machine 462 may be operatively coupled to the accessory gearbox 445. When the blower compressor 420 is operating in the blower mode, the first electrical machine 462 may be operated as a generator to convert mechanical power received from the spool 440 to electrical power. The second electrical machine 464 may be operated as a motor, and may receive at least a portion of the electrical power generated by the first electrical machine via the electrical power management system 466.

The variable transmission 430 further comprises a second input 434. The second input may be configured to receive drive from the second electrical machine 464. For example, a shaft of the second electrical machine may be operatively coupled to the second input. The second electrical machine 464 may be operable by the electrical power management system 466 to drive the variable transmission 430, e.g., the second input of the variable transmission, in either direction.

The variable transmission 430 may be a summing transmission configured such that the speed of the output 436 from the variable transmission 430 is the sum of the speeds of the first and second inputs 432, 434, or a function of the sum. Alternatively, the variable transmission may be configured such that the speed of an output 436 varies based on the speeds of the first and second inputs 432, 434 in any other way.

The electrical power management system 466 may be configured to control the operation of the second electrical machine 464, e.g., the power supplied to the second electrical machine, in order to control the speed of the output 436. The power management system 466 may be configured to provide a continuously-variable difference between the power received from the first electrical machine 462 and the power output to the second electrical machine 464. The power management system 466 may include electrical storage, in the form for example of one or more batteries, capacitors or similar, that enables the power management system to output a different, e.g., less or more, power than is being received by the power management system, e.g., from the first electrical machine, at any particular moment. The electrical power management system 466 may also be configured to control the direction of rotation of the second electrical machine. By varying the speed, direction and power of the second electrical machine 464, the power management system may be configured to control the speed and power supplied from the output of the variable transmission 430 to the blower compressor 420.

In the arrangement depicted in FIG. 4, the variable transmission 430 comprises a differential epicyclic transmission. However, in other arrangements, the variable transmission may comprise any other kind of variable transmission.

In addition to operating in the blower mode, the air pressurisation system 400 can also be operated in a second operating mode, which may be referred to as a starter mode, in which the blower compressor 420 can operate in reverse as an expander to provide drive to the variable transmission 430 and thereby provide mechanical input to the gas turbine engine 10 to facilitate a start operation of the gas turbine engine.

When the air pressurisation system 400 is operating in the starter mode, the second electrical machine 464 can be held stationary, such that the variable transmission 430 transmits the mechanical power from the blower compressor 420 to the spool 440, e.g., via the accessory gearbox 445, to facilitate starting of the gas turbine engine. The remaining steps required for the successful ignition of a gas turbine engine will be known to the person skilled in the art and are therefore not discussed in the present disclosure.

In some arrangements, in the starter mode, the first electrical machine 462, may be operated as a motor and may receive power from the power management system 466. The power received by the first electrical machine 462 may be generated by the second electrical machine 464 operating as a generator, e.g., receiving mechanical power from the blower compressor 420 via the transmission 430. The mechanical power generated by the first electrical machine 462 may be added to that transmitted through the transmission 430 from the blower compressor 420, for driving rotation of the accessory gearbox 445 and thus the spool 440.

In some arrangements, the second electrical machine 464 may be omitted and the first electrical machine 462 may be operated, e.g., under the control of the power management system 466, as a starter-generator to receive power from and provide power to the gas turbine engine, e.g., in order to crank and start the gas turbine engine.

It may be desirable to maintain a temperature of the electrical power management system, e.g., power electronics of the electrical power management system 466, at or below a target maximum operating temperature of the electrical power management system, which may be, for example, less than or equal to 110°C. It may therefore be desirable for the electrical power management system 466 to be located away from the engine core 11, e.g., outside of a fire zone of the engine core 11. The fire zone may be defined as an area within which flammable fluids, e.g., fuel, and sources of ignition are present, e.g., within one or more fuel pipes. Hence, fire suppression systems may be installed within the fire zone. In contrast, a non-fire zone, such as a flammable fluid zone, may be defined as an area in which fuel may be permitted but there is no source of ignition. Accordingly, fire suppression systems may not be installed within non-fire zones, such as the flammable fluid zone. The fire zones and non-fire zones, such as flammable fluid zones, about the core 11 of the gas turbine engine may be separated by one or more bulkheads 470. It may be desirable for the electrical power management system 466 to be positioned on an opposite side of a bulkhead 470 from the engine core, e.g., within the non-fire zone. For example, a section forward of the engine core, which is a flammable fluid zone, may be separated from the engine core zone (which is a fire zone) by the bulkhead 470. The power management system 466 may be provided on the side of the bulkhead 470 forward of the engine core, e.g., in the flammable fluid zone. A temperature within the non-fire zone may be less than or equal to about 110°C. In addition to placing the electrical power management system 466 outside of the fire zone, it may be desirable for the electrical power management system, e.g., the power electronics, to be cooled, e.g., actively cooled, in order to maintain the temperature of the electrical power managements system, e.g., the power electronics at or below the target maximum operating temperature.

With reference to **FIG. 5****,** a power electronics cooling assembly 500 according to arrangements of the present disclosure will now be described. The power electronics cooling assembly 500 comprises a housing 502 including one or more walls 502a defining an interior space 502b for housing power electronics. The housing 502 is mountable to a bulkhead, such as the bulkhead 470, for separating a fire zone from a non-fire zone, such as a flammable fluid zone. In other words, the housing 502 may be mountable to a bulkhead disposed at least partially about a core of a gas turbine engine, such as the engine core 11. For example, the housing 502 may be provided on the opposite side of the bulkhead 470, e.g., from the engine core, forward of the engine core 11. Alternatively, the housing 502 may be provided in a non-fire zone, e.g., a flammable fluid zone, on the opposite side of the bulkhead 470 in any other direction relative to the engine core, such as aft, or on the port or starboard side of the engine core. As described below, the housing 502 may be mountable to the bulkhead via one or more anti-vibration mounts. In some arrangements, the housing 502 may be mountable on the bulkhead, or a casing of the gas turbine engine, via one or more brackets, e.g., to which the housing 502 is coupled via one or more anti-vibration mounts.

The power electronics cooling assembly 500 further comprises a duct 504, for extending between the bulkhead and the housing 502, a fluid supply pipe 506 and a fluid return pipe 508 for extending through the duct 504 from the bulkhead to the housing 502. The fluid supply and return pipes 506, 508 may be suitable for carrying an ignitable fluid coolant, such as fuel. For example the fluid supply and return pipes may be resiliently deformable fuel pipes. More particularly, the fluid supply pipes 506, 508 may be braided flexible pipes/hoses, rubber pipes, or rigid spiralled / coiled (pigtail) pipes. The duct 504 may be a fireproof duct, e.g., manufactured from a fireproof material, such as a fireproof rubber, e.g., Kalrez, or a metallic material. A material of the duct may be selected to be chemically resistant to fluidic contaminants declared within the European Aviation Safety Agency CS-E regulations, and/or those stipulated to be present in gas turbine applications. The duct 504 may be fireproof, e.g., capable of withstanding the application of heat by a standard flame for 15 minutes. A standard flame may have a temperature of 1100°C +/-80°C and Heat Flux Density of 116 kW/m2 +/-10kW/m2, e.g., as defined in EASA CS-130 or AC20-135.

The power electronics cooling assembly 500 further comprises a heat exchange structure 510 arranged within the housing 502. The heat exchange structure is configured to receive the fluid coolant, e.g., ignitable fluid coolant, from the fluid supply pipe 506 and facilitate transfer of heat from the power electronics within the housing 502 to the ignitable fluid. For example, the heat exchange structure 510 may comprise one or more cooling plates, and may be configured such that the ignitable fluid coolant passes over one side of one or more of the cooling plates, and/or through internal cooling channels/circuits of one or more of the cooling plates, and the power electronics are in thermal communication with these cooling plates. For example, respective circuits of the power electronics within the housing 502 may be in thermal communication with different ones of the cooling plates. The cooling plates may be formed from a material with a high thermal conductivity, e.g., relative to a material of the duct 504 and/or pipes 506, 508 and/or housing 502, such as a metal material. The heat exchange structure 510 may be configured to output the ignitable fluid coolant, e.g., that has been in contact with the one or more cooling plates, to the fluid return pipe 508, e.g., so that the ignitable fluid can be returned to the fire zone via the duct 504.

As depicted, an opening 472 may be formed in the bulkhead and a first end 504a of the duct 504 may be coupled to the bulkhead at the opening 472. For example, a wall of the duct may extend about the opening 472. A second end 504b of the duct may be coupled to the housing, e.g., the wall 502a. The wall of the duct 504 may extend around an opening in the wall 502a of the housing at the second end of the duct. The duct 504 may be sealingly coupled to the bulkhead 470 and the housing at the first and second ends of the ducts respectively, so that the interior of the duct is sealed from the flammable fluid zone outside of the housing 502. In this way, the duct 504 may effectively extend the fire zone from the bulkhead 470 up to the housing 502, so that the ignitable fluid coolant can be used as a coolant for the power electronics. In some arrangements, the duct 504 may have a downward trajectory in a direction towards the bulkhead 470, such that any fuel that does leak from the fluid supply and return pipes 506, 508 drains under gravity down the inside of the duct 504 into the fire zone.

As mentioned above, the housing 502 may be mountable to the bulkhead 470. It may be desirable for the power electronics, e.g., the electrical power management system 466, to be vibrationally isolated from the bulkhead 470 or otherwise mounted to reduce the magnitude of vibrations transmitted from the bulkhead 470 to the power electronics, e.g., the electrical power management system 466. Accordingly, the housing 502 may be coupled to the bulkhead via one or more anti-vibration mounts 503. The anti-vibration mounts 503 may be configured to reduce the transmission of vibrations to the housing 502 by encouraging deformation of a resilient material, such as a rubber material, forming a portion of the mount when the bulkhead vibrates relative to the housing. The duct 504 may be resiliently deformable, so that relative movements of the bulkhead and housing can be tolerated by the duct 504.

The power electronics cooling assembly 500 may comprise the electrical power management system 466 described above with reference to FIG. 4.

As depicted in FIG. 5, the electrical power management system 466 may comprise one or more power electronics circuits 466a, which may be collectively referred to as power electronics, for supplying and/or receiving power from the first and/or second electrical machines 462, 464, e.g., respectively. The electrical power management system 466 may further comprise one or more control circuits 466b for controlling the operation of the power electronics. These control circuits may consume significantly less electrical power and therefore may generate significantly less waste heat. Accordingly, the control circuits may not require fluidic cooling. As depicted, the electrical power management system, e.g., the power electronics and optionally the control circuits 436b may be arranged within the housing 502. Further, the power electronics, e.g., the one or more power electronics circuits 436a may be arranged in thermal communication with the heat exchange structure 510 of the power electronics cooling assembly 500.

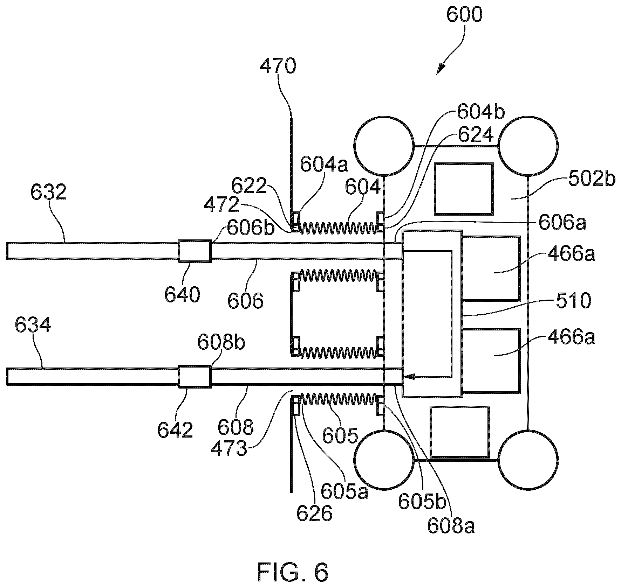

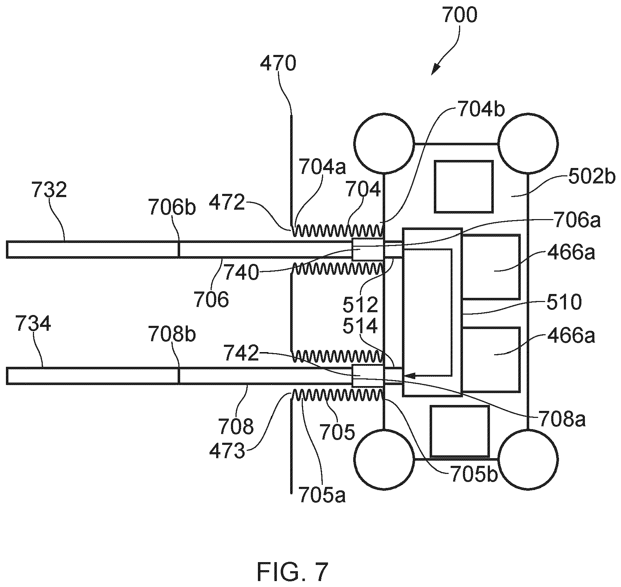

FIGS. 6 and 7 show schematic views of other power electronics cooling assemblies 600, 700 according to further arrangements of the present disclosure. The power electronics cooling assemblies 600, 700 may be similar to the power electronics cooling assembly 500 described above with reference to FIG. 5, and features described above in relation to the power electronics cooling assembly 500 may apply equally to the power electronics cooling assemblies 600, 700 and vice versa.

The power electronics cooling assemblies 600, 700 differs from the power electronics cooling assembly 500 in that the power electronics cooling assemblies 600, 700 comprise two ducts 604, 704, 605, 705 extending between the bulkhead 470 and housing 602, 702, and a fluid supply pipe 606, 706 extends through a first one of the ducts 604, 704 and the fluid return pipe 608, 708 extends through a second one of the ducts 605, 705. In such arrangements, the bulkhead 470 may comprise two openings 472, 473 and first end 604a, 605a, 704a, 705a of the ducts may be coupled to the bulkhead at the respective ones of the openings. Similarly, two openings may be formed in the wall of the housing, and second ends 604b, 605b, 704b, 705b of the ducts may be coupled to the housing at respective ones of the openings.

As illustrated in FIG. 6, the ducts 604, 605 may comprise a corrugated tube. The ducts 604, 605 may be resiliently deformable by virtue of the corrugations. In the arrangements depicted in FIG. 6, the ducts 604, 605 comprise rubber, e.g., fireproof rubber, such as Kalrez, corrugated tubes, which are clamped to flanges 622, 624 formed on the bulkhead and housing, e.g., about the openings in the bulkhead and housing, respectively using hose clamps 626, such as jubilee clips, in order to sealingly couple the ducts 604, 605 to the bulkhead and housing.

Alternatively, as depicted in FIG. 7, the ducts 704, 705 may be directly connected, e.g., brazed, welded and/or mechanically coupled, to the bulkhead and housing at either ends of the ducts 704, 705. As illustrated, in some arrangements, the walls of the ducts 704, 705 may be partially received inside the respective openings 472, 473 in the bulkhead, and the ducts 704,705 may be coupled to the bulkhead around and/or inside the openings. In the arrangements depicted in FIG. 7, the ducts 704, 705 comprise corrugated metallic tubes, e.g., formed from steel, titanium or alloys thereof. For example, the ducts 704, 705 may comprise, or be formed by, edge welded metal bellows or form metal bellows.

The fluid supply pipe 606, 706 and fluid return pipe 608, 708 may be coupled, e.g., fixedly coupled, to the housing 502 at first ends 606a, 706a, 608a, 708a of the fluid supply and return pipes respectively. The first ends 606a, 706a, 608a, 708a of the fluid supply and return pipes may be directly coupled to the heat exchange structure 510. As depicted in FIG. 6, the fluid supply and return pipes 606, 608 may extend into the interior space 502b of the housing, e.g., through the openings in the wall of the housing, to reach the heat exchange structure 510. Alternatively, as depicted in FIG. 7, pipe portions 512, 514 may be arranged inside the housing. The first ends 706a, 708a of the fluid supply and return pipes may be coupled to respective ones of the pipe portions, e.g., at the wall of the housing and the pipe portions may extend from the first ends 706a, 708a of the fluid supply and return pipes to the heat exchange structure 510. The fluid supply and return pipes may be coupled to the respective pipe portions by compression joints, e.g., union joints 740, 742.

The fluid supply and return pipes 606, 706, 608, 708 may extend up to or through the bulkhead, e.g., through the openings 472, 473. Second ends 608b, 706b, 608b, 708b of the fluid supply and return pipes may be coupled to rigid fluid pipes 632, 634, 732, 734, e.g., fuel pipes, on an opposite side of the bulkhead from the housing 602, 702. As illustrated in FIG. 6, the fluid supply and return pipes may be coupled to the rigid fluid pipes, e.g., at their second ends, by compression joints, such as union joints 640, 642, e.g., respective compression joints.

In some arrangements, the power electronics cooling assembly 500, 600, 700 may further comprise a cooler, for cooling the fluid coolant received via the fluid supply pipe before the fluid coolant is supplied to the heat exchange structure.

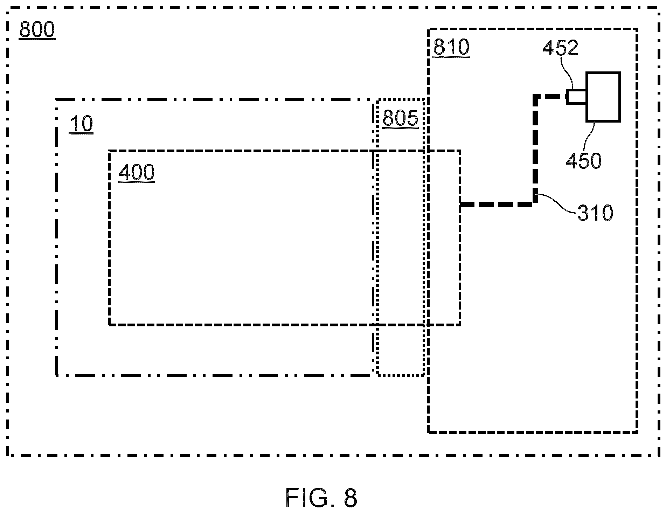

**FIG.** 8 shows a schematic view of an aircraft 800 which includes an airframe 810, a gas turbine engine 10, a pylon 805 and the air pressurisation system 400. The pylon 805 is configured to attach the gas turbine engine 10 to the airframe 810 (e.g., to a wing of the airframe 810), as will be appreciated by those of ordinary skill in the art. The gas turbine engine 10 may be in accordance with the gas turbine engine 10 described above with reference to FIGS. 1 to 3. The air pressurisation system 400, and the power electronics cooling assembly of the air pressurisation system 500, 600, 700 may have any suitable combination of the features described above with respect to the air pressurisation systems 400 and power electronics cooling assembly 500, 600, 700. The air pressurisation system 400 may be at least partially disposed within the gas turbine engine 10, at least partially disposed within the pylon 805 and/or at least partially disposed within the airframe 810. For instance, the blower compressor 420 may be disposed within the gas turbine engine 10. The airframe 810 comprises the airframe system 450 to which the airframe port 452 is configured to supply conditioned and compressed (i.e., pressurised) air from the air pressurisation system 400.

It will be understood that the invention is not limited to the embodiments above-described and various modifications and improvements can be made without departing from the scope of the claims. Except where mutually exclusive, any of the features may be employed separately or in combination with any other features and the disclosure extends to and includes all combinations and sub-combinations of one or more features described herein in accordance with the appended claims.

## Claims

1. A power electronics cooling assembly (500, 600, 700) for a gas turbine engine, the assembly comprising:
a housing (502, 602, 702) for power electronics, wherein the housing is mountable to a bulkhead (470), for separating a fire zone from a non-fire zone of a gas turbine engine (10), in the non-fire zone;
one or more ducts (504, 604, 605, 704, 705) for extending from the bulkhead to the housing;
a fluid supply pipe and a return pipe (506, 508, 606, 608, 706, 708) for extending through the one or more ducts from the bulkhead to the housing, wherein the fluid supply and return pipes are for carrying an ignitable fluid coolant; and
a heat exchange structure (510) arranged within the housing, wherein the heat exchange structure is configured to receive the ignitable fluid coolant from the fluid supply pipe, facilitate transfer of heat from the power electronics within the housing to the ignitable fluid coolant, and output the ignitable fluid coolant to the fluid return pipe,
wherein the assembly comprises anti-vibration mounts (503) for mounting the housing (502, 602, 702) to the bulkhead (470).

2. The power electronics cooling assembly (500, 600, 700) of any of the preceding claims, wherein the duct (504, 604, 605, 704, 705) and/or the fluid supply and return pipes (506, 508, 606, 608) are resiliently deformable.

3. The power electronics cooling assembly (500, 600, 700) of any of the preceding claims, wherein the duct (504, 604, 605, 704, 705) and/or the fluid supply and return pipes (506, 508, 606, 608, 706, 708) are sealingly coupled to the housing (502, 602, 702).

4. The power electronics cooling assembly (500, 600, 700) of any of the preceding claims, wherein the duct (504, 604, 605, 704, 705) and the fluid supply and return pipes (506, 508, 606, 608, 706, 708) are sealingly coupleable to the bulkhead (470).

5. The power electronics cooling assembly (500, 600, 700) of any of the preceding claims, wherein a wall of the duct (504, 604, 605, 704, 705) comprises a plurality of corrugations for enabling resilient deformation of the duct.

6. The power electronics cooling assembly (500, 600, 700) of any of the preceding claims, wherein the one or more ducts (504, 604, 605, 704, 705) are formed from a fireproof material.

7. The power electronics cooling assembly (500, 600, 700) of any of the preceding claims, wherein the assembly comprises a first duct (604, 704) for extending from bulkhead (470) to the housing (502, 602, 702) and a second duct (605, 705) for extending from the bulkhead to the housing, wherein the fluid supply pipe (606, 706) extends through the first duct and the fluid return pipe (608, 708) extends through the second duct.

8. The power electronics cooling assembly (500, 600, 700) of any of the preceding claims, wherein the assembly further comprises fluid supply and return pipe couplings (640, 642) for respectively coupling the fluid supply and return pipes (506, 508, 606, 608, 706, 708) to rigid fluid pipes (632, 634) at or on an opposite side of the bulkhead (470) from the housing (502, 602, 702).

9. A system (400) comprising:
an electrical machine (462) operatively couplable to a spool (440) of a gas turbine engine (10);
power electronics (466a) for controlling the operation of the electrical machine; and
the power electrics cooling assembly (500, 600, 700) of any of the preceding claims, wherein the power electronics are housed within the housing (502, 602, 702).

10. The system (400) of claim 9, wherein, in first operating mode of the system, the electrical machine (462) is configured to operate as a generator to receive power from the spool (440) of the gas turbine engine (10) and supply electrical power to the power electronics (466a) and, in a second operating mode of the system, the electrical machine (462) is configured to operate as a motor to crank the gas turbine engine (10).

11. The system (400) of claim 10, wherein the system further comprises:
a blower compressor (420) configured to be mechanically coupled to a spool (440) of a gas turbine engine (10), and configured to receive an inlet flow of air from a bypass duct (22) of the gas turbine engine and supply compressed air to an airframe (810);
a transmission (430) for mechanically coupling the spool of the gas turbine engine to a rotor of the blower compressor; and
a further electrical machine (464) operatively connected to the transmission, wherein the power electronics (466a) is configured to control the operation of the further electrical machine in order to vary a speed of the transmission relative to a speed of the spool.

12. A gas turbine engine assembly, the assembly comprising:
a gas turbine engine (10) having a core (11);
a bulkhead (470) disposed at least partially about the core of a gas turbine engine; and
the power electronics cooling assembly (500, 600, 700) of any of claims 1 to 8 or the system (400) of any of claims 9 to 11, wherein the housing (502, 602, 702) is coupled to the bulkhead (470).

13. The gas turbine engine assembly of claim 12, wherein the housing (502, 602, 702) is coupled to the bulkhead (470) on an opposite side of the bulkhead from the core (11) of the gas turbine engine.

14. An aircraft (800) comprising an airframe (810), and the gas turbine engine assembly of claim 12 or 13.

## Patentansprüche

1. Leistungselektronik-Kühlanordnung (500, 600, 700) für ein Gasturbinentriebwerk, wobei die Anordnung umfasst:
ein Gehäuse (502, 602, 702) für Leistungselektronik, wobei das Gehäuse an einer Schottwand (470), zum Trennen einer Brandzone von einer Nicht-Brandzone eines Gasturbinentriebwerks (10), in der Nicht-Brandzone montierbar ist;
einen oder mehrere Kanäle (504, 604, 605, 704, 705) zur Erstreckung von der Schottwand zu dem Gehäuse;
eine Fluidversorgungsleitung und eine Rücklaufleitung (506, 508, 606, 608, 706, 708) zur Erstreckung durch den einen oder mehrere Kanäle von der Schottwand zu dem Gehäuse, wobei die Fluidversorgungs- und -rücklaufleitungen dazu dienen, ein zündfähiges Fluidkühlmittel zu befördern; und
eine Wärmetauschstruktur (510), die innerhalb des Gehäuses arrangiert ist, wobei die Wärmetauschstruktur dazu konfiguriert ist, das zündfähige Fluidkühlmittel aus der Fluidversorgungsleitung aufzunehmen, die Übertragung von Wärme von der Leistungselektronik innerhalb des Gehäuses auf das zündfähige Fluidkühlmittel zu begünstigen und das zündfähige Fluidkühlmittel an die Fluidrücklaufleitung abzugeben,
wobei die Anordnung Schwingungsdämpfer (503), zum Montieren des Gehäuses (502, 602, 702) an der Schottwand (470), umfasst.

2. Leistungselektronik-Kühlanordnung (500, 600, 700) nach einem der vorhergehenden Ansprüche, wobei der Kanal (504, 604, 605, 704, 705) und/oder die Fluidversorgungs- und -rücklaufleitungen (506, 508, 606, 608) elastisch verformbar sind.

3. Leistungselektronik-Kühlanordnung (500, 600, 700) nach einem der vorhergehenden Ansprüche, wobei der Kanal (504, 604, 605, 704, 705) und/oder die Fluidversorgungs- und -rücklaufleitungen (506, 508, 606, 608, 706, 708) abdichtend an das Gehäuse (502, 602, 702) gekoppelt sind.

4. Leistungselektronik-Kühlanordnung (500, 600, 700) nach einem der vorhergehenden Ansprüche, wobei der Kanal (504, 604, 605, 704, 705) und die Fluidversorgungs- und -rücklaufleitungen (506, 508, 606, 608, 706, 708) abdichtend an die Schottwand (470) koppelbar sind.

5. Leistungselektronik-Kühlanordnung (500, 600, 700) nach einem der vorhergehenden Ansprüche, wobei eine Wand des Kanals (504, 604, 605, 704, 705) eine Vielzahl von Wellungen, zur Ermöglichung einer elastischen Verformung des Kanals, umfasst.

6. Leistungselektronik-Kühlanordnung (500, 600, 700) nach einem der vorhergehenden Ansprüche, wobei der eine oder mehrere Kanäle (504, 604, 605, 704, 705) aus einem feuerfesten Material gebildet sind.

7. Leistungselektronik-Kühlanordnung (500, 600, 700) nach einem der vorhergehenden Ansprüche, wobei die Anordnung einen ersten Kanal (604, 704) zur Erstreckung von der Schottwand (470) zu dem Gehäuse (502, 602, 702) und einen zweiten Kanal (605, 705) zur Erstreckung von der Schottwand zu dem Gehäuse umfasst, wobei sich die Fluidversorgungsleitung (606, 706) durch den ersten Kanal erstreckt sich und die Fluidrücklaufleitung (608, 708) durch den zweiten Kanal erstreckt.

8. Leistungselektronik-Kühlanordnung (500, 600, 700) nach einem der vorhergehenden Ansprüche, wobei die Anordnung ferner Fluidversorgungs- und -rücklaufleitungskopplungen (640, 642) zum jeweiligen Koppeln der Fluidversorgungs- und -rücklaufleitungen (506, 508, 606, 608, 706, 708) an starre Fluidleitungen (632, 634) an oder auf einer dem Gehäuse (502, 602, 702) gegenüberliegenden Seite der Schottwand (470) umfasst.

9. System (400), umfassend:
eine elektrische Maschine (462), die operativ an eine Spule (440) eines Gasturbinentriebwerks (10) koppelbar ist;
Leistungselektronik (466a) zur Steuerung des Betriebs der elektrischen Maschine; und
die Leistungselektronik-Kühlanordnung (500, 600, 700) nach einem der vorhergehenden Ansprüche, wobei die Leistungselektronik innerhalb des Gehäuses (502, 602, 702) untergebracht ist.

10. System (400) nach Anspruch 9, wobei, in einem ersten Betriebsmodus des Systems, die elektrische Maschine (462) dazu konfiguriert ist, als Generator zu arbeiten, um Leistung aus der Spule (440) des Gasturbinentriebwerks (10) aufzunehmen und die Leistungselektronik (466a) mit elektrischer Leistung zu versorgen und, in einem zweiten Betriebsmodus des Systems, die elektrische Maschine (462) dazu konfiguriert ist, als Motor zu arbeiten, um das Gasturbinentriebwerk (10) anzukurbeln.

11. System (400) nach Anspruch 10, wobei das System ferner umfasst:
einen Gebläsekompressor (420), der dazu konfiguriert ist, mechanisch an eine Spule (440) eines Gasturbinentriebwerks (10) gekoppelt zu sein, und dazu konfiguriert ist, eine Einlassluftströmung aus einem Bypasskanal (22) des Gasturbinentriebwerks aufzunehmen und ein Flugwerk (810) mit Druckluft zu versorgen;
ein Getriebe (430) zum mechanischen Koppeln der Spule des Gasturbinentriebwerks an einen Rotor des Gebläsekompressors; und
eine weitere elektrische Maschine (464), die operativ mit dem Getriebe verbunden ist, wobei die Leistungselektronik (466a) dazu konfiguriert ist, den Betrieb der weiteren elektrischen Maschine zu steuern, um eine Drehzahl des Getriebes relativ zu einer Drehzahl der Spule zu variieren.

12. Gasturbinentriebwerksanordnung, wobei die Anordnung umfasst:
ein Gasturbinentriebwerk (10) mit einem Kern (11);
eine Schottwand (470), die mindestens teilweise um den Kern eines Gasturbinentriebwerks angeordnet ist; und
die Leistungselektronik-Kühlanordnung (500, 600, 700) nach einem der Ansprüche 1 bis 8 oder das System (400) nach einem der Ansprüche 9 bis 11, wobei das Gehäuse (502, 602, 702) an die Schottwand (470) gekoppelt ist.

13. Gasturbinentriebwerksanordnung nach Anspruch 12, wobei das Gehäuse (502, 602, 702) auf einer dem Kern (11) des Gasturbinentriebwerks gegenüberliegenden Seite der Schottwand (470) an die Schottwand gekoppelt ist.

14. Flugzeug (800), umfassend ein Flugwerk (810) und die Gasturbinentriebwerksanordnung nach Anspruch 12 oder 13.

## Revendications

1. Ensemble de refroidissement (500, 600, 700) d'électronique de puissance pour un moteur à turbine à gaz, l'ensemble comprenant :
un boîtier (502, 602, 702) pour l'électronique de puissance, ledit boîtier pouvant être monté sur une cloison (470), pour séparer une zone incendie d'une zone non incendie d'un moteur à turbine à gaz (10), dans la zone non incendie ;
un ou plusieurs conduits (504, 604, 605, 704, 705) destinés à s'étendre à partir de la cloison jusqu'au boîtier ;
un tuyau d'alimentation en fluide et un tuyau de retour (506, 508, 606, 608, 706, 708) destinés à s'étendre à travers le ou les conduits à partir de la cloison jusqu'au boîtier, lesdits tuyaux d'alimentation en fluide et de retour étant destinés à transporter un fluide caloporteur inflammable ; et
une structure d'échange de chaleur (510) agencée à l'intérieur du boîtier, ladite structure d'échange de chaleur étant conçue pour recevoir le fluide caloporteur inflammable provenant du tuyau d'alimentation en fluide, faciliter le transfert de chaleur de l'électronique de puissance à l'intérieur du boîtier vers le fluide caloporteur inflammable, et délivrer en sortie le fluide caloporteur inflammable au tuyau de retour de fluide,
ledit ensemble comprenant des supports antivibratoires (503) pour monter le boîtier (502, 602, 702) sur la cloison (470).

2. Ensemble de refroidissement (500, 600, 700) d'électronique de puissance de l'une quelconque des revendications précédentes, ledit conduit (504, 604, 605, 704, 705) et/ou lesdits tuyaux d'alimentation en fluide et de retour (506, 508, 606, 608) étant élastiquement déformables.

3. Ensemble de refroidissement (500, 600, 700) d'électronique de puissance de l'une quelconque des revendications précédentes, ledit conduit (504, 604, 605, 704, 705) et/ou lesdits tuyaux d'alimentation en fluide et de retour (506, 508, 606, 608, 706, 708) étant couplés de manière étanche au boîtier (502, 602, 702).

4. Ensemble de refroidissement (500, 600, 700) d'électronique de puissance de l'une quelconque des revendications précédentes, ledit conduit (504, 604, 605, 704, 705) et lesdits tuyaux d'alimentation en fluide et de retour (506, 508, 606, 608, 706, 708) pouvant être couplés de manière étanche à la cloison (470).

5. Ensemble de refroidissement (500, 600, 700) d'électronique de puissance de l'une quelconque des revendications précédentes, une paroi du conduit (504, 604, 605, 704, 705) comprenant une pluralité d'ondulations pour permettre une déformation élastique du conduit.

6. Ensemble de refroidissement (500, 600, 700) d'électronique de puissance de l'une quelconque des revendications précédentes, ledit ou lesdits conduits (504, 604, 605, 704, 705) étant formés à partir d'un matériau ignifuge.

7. Ensemble de refroidissement (500, 600, 700) d'électronique de puissance de l'une quelconque des revendications précédentes, ledit ensemble comprenant un premier conduit (604, 704) destiné à s'étendre à partir de la cloison (470) jusqu'au boîtier (502, 602, 702) et un second conduit (605, 705) destiné à s'étendre à partir de la cloison jusqu'au boîtier, ledit tuyau d'alimentation en fluide (606, 706) s'étendant à travers le premier conduit et ledit tuyau de retour de fluide (608, 708) s'étendant à travers le second conduit.

8. Ensemble de refroidissement (500, 600, 700) d'électronique de puissance de l'une quelconque des revendications précédentes, ledit ensemble comprenant en outre des raccords de tuyaux d'alimentation en fluide et de retour (640, 642) pour coupler respectivement les tuyaux d'alimentation en fluide et de retour (506, 508, 606, 608, 706, 708) à des tuyaux de fluide rigides (632, 634) au niveau ou sur un côté opposé de la cloison (470) par rapport au boîtier (502, 602, 702).

9. Système (400) comprenant :
une machine électrique (462) pouvant être couplée fonctionnellement à un corps (440) d'un moteur à turbine à gaz (10) ;
une électronique de puissance (466a) pour commander le fonctionnement de la machine électrique ; et l'ensemble de refroidissement (500, 600, 700) d'électronique de puissance de l'une quelconque des revendications précédentes, ladite électronique de puissance étant logée à l'intérieur du boîtier (502, 602, 702).

10. Système (400) de la revendication 9, dans un premier mode de fonctionnement du système, ladite machine électrique (462) étant conçue pour fonctionner en tant que générateur afin de recevoir une puissance en provenance du corps (440) du moteur à turbine à gaz (10) et alimenter en puissance électrique l'électronique de puissance (466a) et, dans un second mode de fonctionnement du système, ladite machine électrique (462) étant conçue pour fonctionner en tant que moteur afin de lancer le moteur à turbine à gaz (10).

11. Système (400) de la revendication 10, ledit système comprenant en outre :
un compresseur de ventilateur (420) conçu pour être couplé mécaniquement à un corps (440) d'un moteur à turbine à gaz (10), et conçu pour recevoir un flux d'entrée d'air en provenance d'une conduite de dérivation (22) du moteur à turbine à gaz et alimenter en air comprimé un fuselage (810) ;
une transmission (430) pour coupler mécaniquement le corps du moteur à turbine à gaz à un rotor du compresseur de ventilateur ; et
une machine électrique supplémentaire (464) raccordée fonctionnellement à la transmission, ladite électronique de puissance (466a) étant conçue pour commander le fonctionnement de la machine électrique supplémentaire afin de faire varier une vitesse de la transmission par rapport à une vitesse du corps.

12. Ensemble de moteur à turbine à gaz, l'ensemble comprenant :
un moteur à turbine à gaz (10) possédant un noyau (11) ;
une cloison (470) disposée au moins partiellement autour du noyau d'un moteur à turbine à gaz ; et
l'ensemble de refroidissement (500, 600, 700) d'électronique de puissance de l'une quelconque des revendications 1 à 8 ou le système (400) de l'une quelconque des revendications 9 à 11, ledit boîtier (502, 602, 702) étant couplé à la cloison (470).

13. Ensemble moteur à turbine à gaz de la revendication 12, ledit boîtier (502, 602, 702) étant couplé à la cloison (470) sur un côté opposé de la cloison par rapport au noyau (11) du moteur à turbine à gaz.

14. Aéronef (800) comprenant un fuselage (810) et l'ensemble moteur à turbine à gaz de la revendication 12 ou 13.
